Europäisches Patentamt

European Patent Office

Office européen des brevets

(11) Publication number: **0 186 336**
**B1**

# EUROPEAN PATENT SPECIFICATION

(45) Date of publication of patent specification: 09.08.89

(21) Application number: 85308730.2

(22) Date of filing: 29.11.85

(51) Int. Cl.⁴: **H 01 L 29/205,** H 01 S 3/19,
H 01 L 33/00

(54) Semiconductor device comprising a superlattice structure.

(30) Priority: 29.11.84 JP 253885/84

(43) Date of publication of application:
02.07.86 Bulletin 86/27

(45) Publication of the grant of the patent:
09.08.89 Bulletin 89/32

(84) Designated Contracting States:
DE GB NL

(56) References cited:
EP-A-0 166 593
US-A-4 163 237
US-A-4 205 329

PATENTS ABSTRACTS OF JAPAN, vol. 8, no.
53 (E-231) 1490r, 9th March 1984; & JP - A - 58
207 684 (NIPPON DENSHIN DENWA KOSHA)
03-12-1983

APPLIED PHYSICS LETTERS, vol. 44, no. 4,
February 1984, pages 435-437, American
Institute of Physics, New York, US; W.T.
MASSELINK et al.: "Improved GaAs/AlGaAs
single quantum wells through the use of thin
superlattice buffers"

(73) Proprietor: **SHARP KABUSHIKI KAISHA**
**22-22 Nagaike-cho Abeno-ku**
**Osaka 545 (JP)**

(72) Inventor: **Hayakawa, Toshiro**
**17-402, Katsuragi-cho**
**Nara-shi Nara-ken (JP)**
Inventor: **Suyama, Takahiro**
**2613-1, Ichinomoto-cho**
**Tenri-shi Nara-ken (JP)**
Inventor: **Takahashi, Kohsei**
**2613-1, Ichinomoto-cho**
**Tenri-shi Nara-ken (JP)**
Inventor: **Yamamoto, Saburo**
**1-2-11, Akanedai Haibara-cho**
**Uda-gun Nara-ken (JP)**

(74) Representative: **White, Martin David et al**
**MARKS & CLERK 57/60 Lincoln's Inn Fields**
**London WC2A 3LS (GB)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

## Description

Background of the invention

1. Field of the invention:

This invention relates to a semiconductor device such as a semiconductor laser device, a transistor, etc., which contains semiconductor multiple thin films formed by molecular beam epitaxy (MBE), metal-organic chemical vapor deposition (MO-CVD), etc.

2. Description of the prior art:

Recently, a single crystal growth technique for the formation of thin films such as molecular beam epitaxy (MBE), metal-organic chemical vapor deposition (MO-CVD), etc., has been developed which enables the formation of thin film growth layers having a thickness of as thin as approximately 10 Å (1Å=10⁻¹⁰ metre). The development of such a technique allowed the production of the thin film layers to be applied to laser devices. However, these significantly thin film layers have not yet been produced by liquid phase epitaxy (LPE).

An example of these laser devices is a superlatticed device having a periodic multiple-layered structure of plural semiconductor thin films. Typical superlatticed devices are composed of alternate layers, each layer consisting of two kinds of thin semiconductor films (the thickness thereof being approximately 100 Å or less) which are typically made of $Ga_{1-x}Al_xAs$ ($0\leqq x\leqq 1$). Since the lattice constants of two different $Ga_{1-x}Al_xAs$ materials are well matched, lattice defects based on internal stresses is rare.

The main feature of the superlattices is that multiple-layered thin films are formed with a periodicity which is longer than the lattice constant (several Å), resulting in repeat of the band structure in the reciprocal lattice space thereof. Such a deformity of the band structure allows the regulation of electrical characteristics of the superlattices. For instance, a superlattice which is composed of alternate layers consisting of two GaAs layers and two AlAs layers proviees a multiple-layered structure having a periodicity which is two times the lattice constant, resulting in a band structure which is folded to the two halves of the Brillouin band in the reciprocal lattice space in the lamination direction. As mentioned above, the main feature of superlattices is that the band structure can be changed without changing the kinds of crystal elements. However, so long as $Ga_{1-x}Al_xAs$ materials are used for the formation of superlattices, the change of the band structure is attained only by either a change of the AlAs mole fraction x or a change of the layer thickness of the two kinds of $Ga_{1-x}Al_xAs$ layers, so that a change of the band structure can be only attained in a limited range.

On the other hand, in the case where even such bulk crystals as of a SiC crystal are of a poly-type (i.e., 2H type, 3C type and 6H type), even if one of the various type crystals had the same elements and composition ratio as another, various crystals having different crystal structure and different band structure can be obtained when the elements of each of the crystals are arranged with a different periodicity. That is, with regard to the lamination of SiC layer units in the direction of the C-axis, three kinds of lattice positions (hereinafter referred to as A, B and C) exist; for example, the 2H type crystal provides a superlatticed structure of ABAB . . ., the 3C type crystal provides a superlatticed structure of ABCABC . . . and the 6H type crystal provides a superlatticed structure of ABCACBABCACB . . . Moreover, the energy gaps of the 2H type, the 3C type and the 6H type are 3.33 eV, 2.39 eV and 3.02 eV, respectively, which are quite different from each other. Artificial polytype superlattices can be produced by the use of three or more kinds of crystal elements. For instance, a superlattice which results from the periodical lamination of InSb layers (the thickness of each layer being 50 Å), GaSb layers (the thickness of each layer being 50 Å) and AlSb layers (the thickness of each layer being 50 Å) is different in band structure from another superlattice which results from the periodical lamination of InSb layers (the thickness of each layer being 50 Å), GaSb layers (the thickness of each layer being 50 Å), InSb layers (the thickness of each layer being 50 Å) and AlSb layers (the thickness of each layer being 50 Å). However, these polytype superlattices must be composed of three or more kinds of crystal elements and cannot be produced using the combination of GaAs and AlAs, the lattice constants of which are well matched.

On the other hand, superlattices can be designed using the combination of semiconductor thin layers (e.g., $GaAs_{1-x}P_x$ ($x<1$) and GaP, $In_xGa_{1-x}As$ ($x<0$) and GaAs, etc.), the lattice constants of which are not matched. When the thickness of each layer of these superlattices, which are so-called strained superlattices, is approximately 100 Å or less, the internal stress due to the matchless lattice constants therebetween is too small to cause dislocation and accordingly the resulting crystals have almost no lattice defects therein. Thus, the use of such strained superlattices enlarges the degree of freedom in the choice of materials. Since energy gaps of superlattices are generally greater than those of the semiconductor thin layers constituting the superlattices, the use of a superlattice for the active region of a semiconductor laser device enables the shortening of the oscillation wavelength of laser light which is produced by the device. However, when strained superlattices are employed for the active region, the rapid formation of lattice defects and the multiplication thereof occur, making it difficult to put such strained superlattices to practical use.

The prior publication "Applied Physics Letters", vol. 44, February 1984, No. 4, pages 435 to 437, discloses a semiconductor device comprising a multiplicity of films of different compounds forming a superlatticed structure having a plurality of different layers, the films of one said compound being in respectively different thicknesses, forming an improved GaAs, AlGaAs single quantum well through the use of thin superlattice buffers.

The present invention provides a semiconductor device according to each of claims 1, 2 and 3, to which reference is directed.

Brief description of the drawings

This invention may be better understood and its numerous objects and advantages will become apparent to those skilled in the art by reference to the accompanying drawings as follows:

Figure 1 is a diagram showing the distribution of the AlAs mole fraction (i.e., x) in a $Ga_{1-x}Al_xAs$ superlatticed semiconductor laser device of this invention.

Figure 2 is a diagram showing the distribution of the AlAs mole fraction (i.e., x) in a conventional $Ga_{1-x}Al_xAs$ superlatticed semiconductor laser device.

Description of the preferred embodiments

A superlatticed semiconductor laser device of this invention is described below in comparison with a conventional semiconductor laser device:

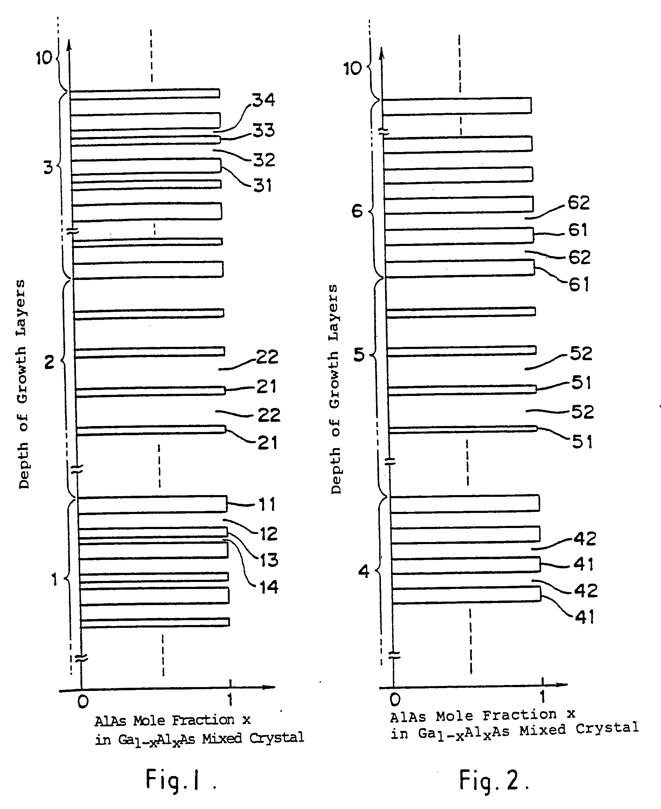

Figure 2 shows the distribution of the AlAs mole fraction x in a $Ga_{1-x}Al_xAs$ mixed crystal in a conventional superlatticed semiconductor laser device consisting of two kinds of binary compounds (i.e., GaAs and AlAs), wherein the abscissa is the AlAs mole fraction of 1 and the GaAs mole fraction of 0 and the ordinate is the dimension in the direction of the thicknesses of the growth layers. This conventional superlatticed semiconductor laser device is produced as follows: On an n-GaAs substrate (not shown), a layered portion in the form of a superlatticed cladding layer 4 which is composed of alternate layers consisting of two hundred fifty n-GaAs layers (the thickness of each layer being 20 Å) 42 and two hundred-fifty n-AlAs layers (the thickness of each layer being 20 Å) 41, another layered portion in the form of a superlatticed active layer 5 which is composed of alternate layers consisting of ten non-doped GaAs layer (the thickness of each layer being 40 Å) 52 and nine non-doped AlAs layers (the thickness of each layer being 10 Å) 51, another layered portion comprising a superlatticed cladding layer 6 which is composed of alternate layers consisting of two hundred fifty p-AlAs layers (the thickness of each layer being 20 Å) 61 and two hundred forty nine p-GaAs layer (the thickness of each layer being 20 Å) 62, and a layered portion comprising a p-GaAs cap layer 10 having a thickness of 0.5 μm are successively grown by molecular beam epitaxy. On the resulting wafer, an $Al_2O_3$ oxide film having a striped structure with a stripe width of 10 μm and a cavity length of 250 μm is then formed to obtain a superlatticed semiconductor laser device which oscillates laser light having an oscillation wavelength of 750 nm at a threshold current Ith of 80 mA.

Figure 1 shows the distribution of the AlAs mole fraction x in a $Ga_{1-x}Al_xAs$ mixed crystal in a superlatticed semiconductor laser device of this invention consisting of two kinds of binary compounds (e.g., GaAs and AlAs), wherein the abscissa is the same AlAs mole fraction as that of Figure 2 and the ordinate is the same dimension as that of Figure 2. This superlatticed semiconductor laser device of this invention is produced as follows: On an n-GaAs substrate (not shown), four layered portions including a superlatticed cladding layer 1, a superlatticed active layer 2, a further superlatticed cladding layer 3 and a p-cap layer 10, said superlatticed cladding layer 1 is composed of periodic layers consisting of one hundred fifty n-GaAs layers (the thickness of each layer being 10 Å) 14, one hundred fifty n-AlAs layers (the thickness of each layer being 10 Å) 13, one hundred fifty n-GaAs layers (the thickness of each layer being 20 Å) 12 and one hundred fifty n-AlAs layers (the thickness of each layer being 20 Å) 11; said superlatticed active layer 2 is composed of alternate layers consisting of ten non-doped GaAs layers (the thickness of each layer being 40 Å) 22 and nine non-doped AlAs layers (the thickness of each layer being 10 Å) 21; said further superlatticed cladding layer 3 is composed of periodic layers consisting of one hundred fifty p-AlAs layers (the thickness of each layer being 20 Å) 31, one hundred fifty p-GaAs layers (the thickness of each layer being 20 Å) 32, one hundred fifty p-AlAs layers (the thickness of each layer being 10 Å) 33 and one hundred forty nine p-GaAs layers (the thickness of each layer being 10 Å) 34; and said p-cap layer 10 having a thickness of 0.5 μm are successively grown by molecular beam epitaxy. On the resulting wafer, an $Al_2O_3$ oxide film having a striped structure with a stripe width of 10 μm and a cavity length of 250 μm is then formed, resulting in a superlatticed semiconductor laser device which has the same oscillation characteristics as the above-mentioned conventional device attaining laser oscillation with an oscillation wavelength of 750 nm at a threshold current Ith of 80 mA.

The active layer 2 in the above-mentioned laser device of this invention shown in Figure 1 is the same structure as the active layer 5 in the conventional laser device shown in Figure 2, and moreover the far-field pattern in the direction which is vertical to the junctions of the active layer 2 in the laser device of this invention exhibits a lobe full-width of the half maximum of approximately 25 degrees, which is the same as in the conventional laser device shown in Figure 2. Thus, the refraction indexes of the cladding layers 1 and 3, in the laser device of this invention are nearly equal to those of the cladding layers 4 and 6, respectively, in the conventional laser device shown in Figure 2.

The relationship between the threshold current Ith and the specific temperature To of both the superlatticed semiconductor laser devices mentioned above can be represented by the formula:

$$Ith \propto exp\ (T/To)$$

wherein T is a temperature in the oscillation region to be examined, but which falls in the range of 20°C to 70°C at which current leakage into the cladding layers becomes essential to the determination of the temperature characteristics of these semiconductor laser devices:

Pulse current having a pulse-time of 1 μsec. and a frequency of 1 KHz was used for the determination of the temperature characteristics of the above-mentioned superlatticed semiconductor laser devices, resulting in a specific temperature To of 120°K for the conventional laser device shown in Figure 2 whereas a specific temperature of 160°K for the laser device of this invention shown in Figure 1 which is significantly greater than that of the conventional laser device. This indicates that the effective energy gap between the cladding layers 1 and 3 in the laser device of this invention shown in Figure 1 is greater than that between the cladding layers 4 and 6 in the conventional laser device shown in Figure 2. It can be understood that the superlatticed semiconductor laser device of this invention enables the change of the band structure therein without changing the refraction index thereof.

This invention is not limited to the above-mentioned superlattice, but can be applied to another novel superlattice which contains, as a lattice unit, periodic layers consisting of two AlAs layers, three GaAs layers, two AlAs layers, two GaAs layers, one AlAs layer, two GaAs layers, two AlAs layers and three GaAs layers. According to this superlatticed structure, the modulation of a layer thickness can be obtained.

The lattice unit which is composed of periodically laminated layers consisting of four kinds of thin layers can be applied to the active layer in addition to or instead of the cladding layers. Moreover, the kinds of thin layers constituting the lattice unit can be set to be more than four by the use of thin layers with different thicknesses (e.g., 10 Å, 20 Å and 30 Å).

Although conventional superlattices are designed with the repetition of potentials, which are greater or smaller than those of the carrier therein, to thereby attain a superlatticed structure having a periodicity which is longer than that of a superlattice unit of bulk crystal, the above-mentioned superlattice of this invention allows for the repetition of potentials with a longer periodicity than the conventional superlattices thereby attaining a different band structure from conventional band structures. Thus, the superlatticed structure of this invention can be also applied to field effect transistors (FET), high electron mobility transistors (HEMT), light emitting diodes (LED), etc.

## Claims

1. A semiconductor device comprising a multiplicity of layers (11—14, 21, 22, 31—34) of different compounds (GaAs, AlAs) forming a superlatticed structure having a plurality of different layered portions (1, 2, 3), the layers (12, 14, 22, 32, 34) of at least one said compound (GaAs) being in respectively different thicknesses (1 mm, 2 mm, 4 mm) (10 Å 20 Å, 40 Å), characterised in that the layered portions consist of four or more layers, the layers (11—14, 31—34) of said different compounds (GaAs, AlAs) are of different thicknesses (1 nm, 2 nm) (10 Å, 20 Å) for more than one individual compound (GaAs, AlAs) in at least one individual layered portion (1, 3), the individual layered portion itself being superlatticed, the arrangement of the thickness (1 nm, 2 nm) (10 Å, 20 Å) and compounds (GaAs, AlAs) of the layers (11—14, 31—34) in said individual layered portion being periodic.

2. A semiconductor device according to claim 1, wherein said compounds are binary compounds of GaAs and AlAs.

3. A semiconductor device according to claim 1 or 2 forming a laser device, wherein said layered portions comprise cladding layers (1, 3) sandwiching an active layer (2) therebetween, the cladding layers (1, 3) each forming a said individual layer (1, 3), the layers (21, 22) of each individual compound (GaAs, AlAs) in the active active layer (2) being a single thickness (4 nm, 1 nm) (40 Å, 10 Å).

## Patentansprüche

1. Halbleitereinrichtung mit einer Mehrzahl von Schichten (11—14, 21, 22, 31—34) aus verschiedenen Verbindungen (GaAs, AlAs), die einen Überstruktur-Gitteraufbau bilden, der eine Anzahl von verschiedenen Schichtabschnitten (1, 2, 3) besitzt, wobei die Schichten (12, 14, 22, 32, 34) der zumindest einen Verbindung (GaAs) jeweils verschiedene Dicken (1 nm, 2 nm, 4 nm) (10 Å, 20 Å, 40 Å) haben, dadurch gekennzeichnet, daß die Schichtabschnitte aus vier oder mehr Schichten bestehen, wobei die Schichten (11—14, 31—34) aus verschiedenen Verbindungen (GaAs, AlAs) unterschiedliche Dicken (8 nm, 2 nm) (10 Å, 20 Å), für mehr als eine individuelle Verbindung (GaAs, AlAs) in zumindest einem individuellen Schichtabschnitt (1, 3) haben, wobei der individuelle Schichtabschnitt selbst ein Überstrukturgitter ist, und daß die Anordnung der Dicken (1 nm, 2 nm) (10 Å, 20 Å) und die Verbindungen (GaAs, AlAs) der Schichten (11—14, 31—34) in dem individuellen Schichtabschnitt periodisch sind.

2. Halbleitereinrichtung nach Anspruch 1, wobei die Verbindungen binäre Verbindungen vom GaAs und AlAs sind.

3. Halbleitereinrichtungen nach Anspruch 1 oder 2, die eine Lasereinrichtung bildet, wobei die Schichtabschnitte Auskleidungsschichten (1, 3) aufweisen, die dazwischen eine aktive Schicht (2) einschließen, wobei die Auskleidungsschichten (1, 3) jeweils eine der individuellen Schichten (1, 3) bilden und die Schichten (21, 22) jeder individuellen Verbindung (GaAs, AlAs) in der aktiven Schicht (2) eine einzige Dicke (4 nm, 1 nm) (40, 10 Å) haben.

**Revendications**

1. Dispositif à semi-conducteur comprenant plusieurs couches (11—14, 21, 22, 31—34) de composés différents (GaAs, AlAs) formant une superstructure ayant plusieurs parties différentes en couches (1, 2, 3), les couches (12, 14, 22, 32, 34) de l'un au moins des composés (GaAs) ayant des épaisseurs différentes (1 nm, 2 nm, 4 nm) (10 Å, 20 Å, 40 Å), caractérisé en ce que les parties disposées en couches sont formées d'au moins quatre couches, les couches (11—14, 31—34) des composés différents (GaAs, AlAs) ont des épaisseurs différentes (1 nm, 2 nm) (10 Å, 20 Å) pour plus d'un composé individuel (GaAs, AlAs) dans au moins une partie individuelle en couches (1, 3), la partie individuelle en couches elle-même ayant une superstructure, la disposition des épaisseurs (1 nm, 2 nm) (10 Å, 20 Å) et des composés (GaAs, AlAs) des couches (11—14, 31—34) dans la partie individuelle en couches étant périodique.

2. Dispositif à semi-conducteur selon la revendication 1, dans lequel les composés sont des composés binaires de GaAs et AlAs.

3. Dispositif à semi-conducteur selon la revendication 1 ou 2, formant un dispositif laser, dans lequel les parties en couches comportent des couches de revêtement (1, 3) disposées autour d'une couche active (2) placée entre elles, les couches de revêtement (1, 3) formant chacune une couche individuelle (1, 3) précitée, les couches (21, 22) de chaque composé individuel (GaAs, AlAs) de la couche active (2) ayant une seule épaisseur (4 nm, 1 nm) (40 Å, 10 Å).

Fig.1.

Fig.2.